# DEMANDE DE BREVET EUROPEEN

(11) **EP 1 248 155 A1**
(43) Date de publication de la demande: **09.10.2002**
(21) Numéro de dépôt: 02290747.1
(22) Date de dépôt: 25.03.2002
(51) Int. Cl.: G03F 7/20

(54) **Procédé d'illumination d'une couche d'une matière**

(30) Priorité: 03.04.2001 FR 0104514
(71) Demandeur: STMicroelectronics S.A., 92120 Montrouge (FR); Commisariat à l'énergie Atomique, 75015 Paris 15ème (FR)
(72) Inventeur: Manakli, Serdar, 38000 Grenoble (FR); Trouillet, Yorick, 38000 Grenoble (FR)
(74) Mandataire: Casalonga, Axel

(57) **Abrégé**

Procédé d'illumination d'une couche d'une matière, en particulier une résine photosensible, à partir d'une source de lumière en vue d'exposer une zone de cette matière à une dose utile de lumière permettant de réaliser ultérieurement une attaque de cette matière dans cette zone, consistant à effectuer une première exposition au travers d'un motif d'un premier masque composé d'un trou central (15) et de trous périhériques (16), sous une première dose de lumière inférieure à ladite dose utile; et une seconde exposition au travers d'un motif d'un second masque composé d'un trou unique (21) et sous une seconde dose de lumière telle que le cumul (23) de ladite première dose induite au travers du trou central (15) du premier masque et de cette seconde dose (22) induite au travers du trou unique (21) dudit second masque permette d'obtenir au moins ladite dose utile (18) sur ladite zone (25).

## Description

La présente invention concerne le domaine de la photo-lithographie mise en oeuvre en particulier dans le domaine de la fabrication des circuits intégrés.

Dans l'industrie des semi-conducteurs, on cherche continuellement à réduire la taille des composants élémentaires des circuits intégrés fabriqués en grand nombre sur des plaquettes, afin d'obtenir des circuits intégrés de plus en plus performants et de plus en plus petits.

Lors de la fabrication de circuits intégrés sur des plaquettes, il est courant de mettre en oeuvre des étapes de photo-lithographie qui consistent à réaliser une exposition à la lumière d'une couche de résine photo-sensible telle qu'après une attaque des parties insolées apparaissent des motifs tridimensionnels dans la couche de résine. C'est le cas en particulier lorsqu'il s'agit de réaliser des trous de contact permettant des interconnexions électriques entre les différentes couches des circuits intégrés.

En ce qui concerne cette étape de photo-lithographie, une amélioration des performances est générée par une diminution de la résolution des motifs exposés qui, traditionnellement, passe par une diminution de la longueur d'onde de la lumière d'exposition.

Lorsqu'il s'agit de réaliser un trou dans une couche de résine photo-sensible, il est courant d'effectuer une exposition ou illumination unique au travers d'un masque présentant un trou unique au travers duquel passe la dose de lumière nécessaire pour permettre une attaque ultérieure de la couche de résine. Il a aussi été proposé d'effectuer une exposition unique au travers d'un masque présentant un trou central et des trous périphériques, la dose de lumière nécessaire pour permettre une attaque ultérieure de la couche de résine passant uniquement au travers du trou central.

Par ailleurs, il est connu d'effectuer une illumination multidirectionnelle du masque ou d'utiliser une illumination quadripolaire ou annulaire du masque grâce à un obstacle central placé entre la source de lumière et ce masque.

Il a pu être observé que les moyens ci-dessus décrits présentent des limites lorsqu'il s'agit de réaliser en particulier des trous isolés dans une couche de résine photo-sensible présentant des dimensions allant en se réduisant.

Le but de la présente invention est de proposer un procédé d'illumination d'une couche d'une matière, en particulier d'une résine photosensible, à partir d'une source de lumière en vue d'exposer une zone de cette matière à une dose utile de lumière permettant de réaliser ultérieurement une attaque de cette matière dans cette zone, permettant d'améliorer et d'augmenter les performances de cette opération d'insolation de la matière dans ladite zone, notamment pour la réalisation ultérieure de trous de très petites dimensions dans la couche de résine.

Selon l'invention, ce procédé consiste : à placer entre la source de lumière et la couche de matière un premier masque présentant un motif composé d'un trou central et de trous placés à la périphérie de ce trou central ; à effectuer une première exposition au travers dudit motif dudit premier masque sous une première dose de lumière inférieure à ladite dose utile ; à placer entre la source de lumière et la couche de matière un second masque présentant un motif composé d'un trou unique, en disposant ce second masque dans une position telle que son trou unique corresponde au trou central du premier masque ; et à effectuer une seconde exposition au travers dudit motif dudit second masque sous une seconde dose de lumière telle que le cumul de ladite première dose induite au travers du trou central du premier masque et de cette seconde dose induite au travers du trou unique dudit second masque permette d'obtenir au moins ladite dose utile sur ladite zone.

Selon l'invention, le procédé peut avantageusement consister à effectuer la seconde exposition sous une seconde dose de lumière inférieure à ladite dose utile.

Selon l'invention, le trou unique du second masque présente de préférence une surface supérieure à celle du trou central du premier masque.

Selon l'invention, le procédé peut avantageusement consister à effectuer la première exposition sous une illumination quadripolaire ou annulaire.

Selon l'invention, le procédé peut avantageusement consister à effectuer la seconde exposition sous une illumination quadripolaire ou annulaire.

Selon l'invention, lesdits premier et second motifs peuvent avantageusement être réalisés sur un masque unique ou sur deux masques séparés.

La présente invention sera mieux comprise à l'étude d'un procédé d'illumination ou d'exposition à la lumière d'une matière photo-sensible à insoler localement, décrit à titre d'exemple non limitatif et illustré par le dessin sur lequel :
- la figure 1 représente un schéma optique d'un appareillage de photo-lithographie ;
- la figure 2a représente un premier masque utilisé dans le procédé selon la présente invention ;
- la figure 2b représente, selon un axe médian II-II de la figure 2a, une courbe de répartition de la quantité de lumière atteignant la matière à insoler, au travers du masque de la figure 2a ;
- la figure 3a représente un second masque utilisé dans le procédé selon la présente invention ;
- la figure 3b représente une courbe de répartition de la quantité de lumière atteignant la matière à insoler, au travers du masque de la figure 3a ;
- la figure 4 représente une courbe de la somme des quantités de lumière atteignant la matière à insoler ;
- et la figure 5 représente une vue de dessus de la matière après insolation.

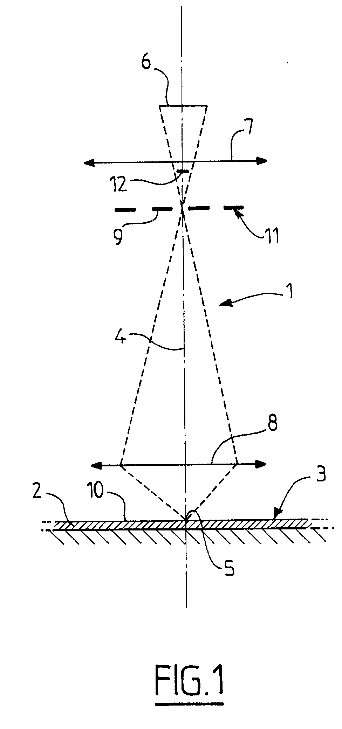

En se reportant à la figure 1, on voit qu'on a représenté un appareillage 1 d'insolation ou de photo-lithographie permettant d'exposer à la lumière une couche de résine photo-sensible 2 d'une plaquette 3 de circuits intégrés en cours de fabrication.

Cet appareillage 1 comprend, sur un axe optique 4 s'étendant perpendiculairement à la plaquette 3 correspondant à l'axe d'un trou 5 à réaliser dans la couche de résine 2, successivement une source de lumière 6, un condenseur 7 et une pupille d'entrée 8, tels qu'un plan focal 9 s'étend entre le condenseur 7 et la pupille d'entrée 8 et qu'un plan focal 10 s'étend sur la couche de résine photo-sensible 2.

Dans le plan focal 9, l'appareillage 1 comprend un support 11 susceptible de recevoir un masque et un obstacle est placé selon l'axe optique 4, entre le condenseur 6 et le plan focal 9, de façon à produire une illumination ou un faisceau lumineux quadripolaire ou annulaire.

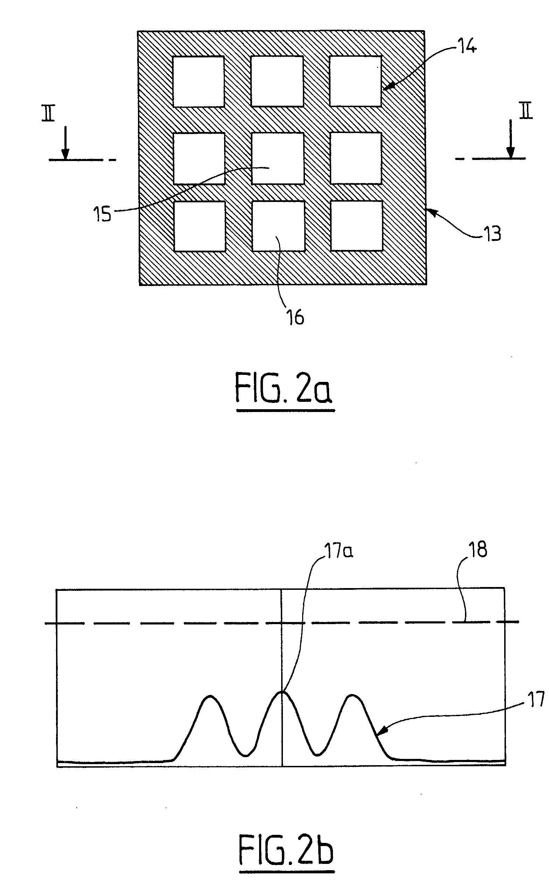

En se reportant à la figure 2a, on voit qu'on a représenté un premier masque ou réticule 13 qui comprend un motif 14 constitué par un trou central carré 14 et huit trous périphériques carrés 15 répartis autour et à distance du trou central 14, de façon à constituer une matrice de neuf trous régulièrement répartis.

Ayant installé le masque 13 dans le support de masque 11 de l'appareillage 1 dans une position telle que l'axe du trou central 15 est sur l'axe optique 4, on procède à une illumination de la couche de résine photo-sensible 2 au travers du motif 14.

En se reportant à la figure 2b, on voit que les doses de lumière traversant le trou central 15 et les trous périphériques 16 du motif 14 du masque 13 sont en forme de neuf cloches 17 et que la source de lumière 6 est activée de telle sorte que ces doses 17 présentent des valeurs maximum 17a qui sont inférieures à un niveau de dose utile 18.

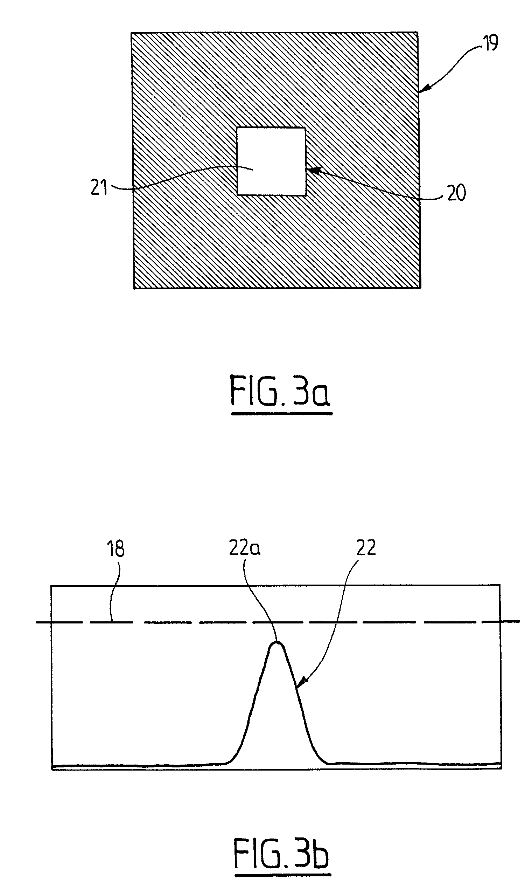

En se reportant à la figure 3a, on voit qu'on a représenté un second masque 19 qui présente un motif 20 composé d'un trou carré unique 21 dont la surface est supérieure à celle du trou central 15 du motif 14 du premier masque 13.

Ayant placé le second masque 19 sur le support 11 de l'appareil 1 dans une position telle que l'axe du trou unique 21 est sur l'axe optique 4, on procède à une illumination de la couche de résine photo-sensible 2 de la plaquette 3.

En se reportant à la figure 3b, on voit que la dose de lumière traversant le trou unique 21 du second masque 19 est en forme de cloche 22 et que la source de lumière 6 est activée de telle sorte que cette dose 22 présente une valeur maximum 22a qui est inférieure au niveau de la dose utile 18.

Il résulte de ce qui précède que la couche de résine photo-sensible 2 de la plaquette reçoit une illumination au travers du motif 14 du premier masque 13, puis une illumination au travers du motif 20 du second masque 19, conduisant au cumul d'une première dose de lumière et d'une seconde dose de lumière

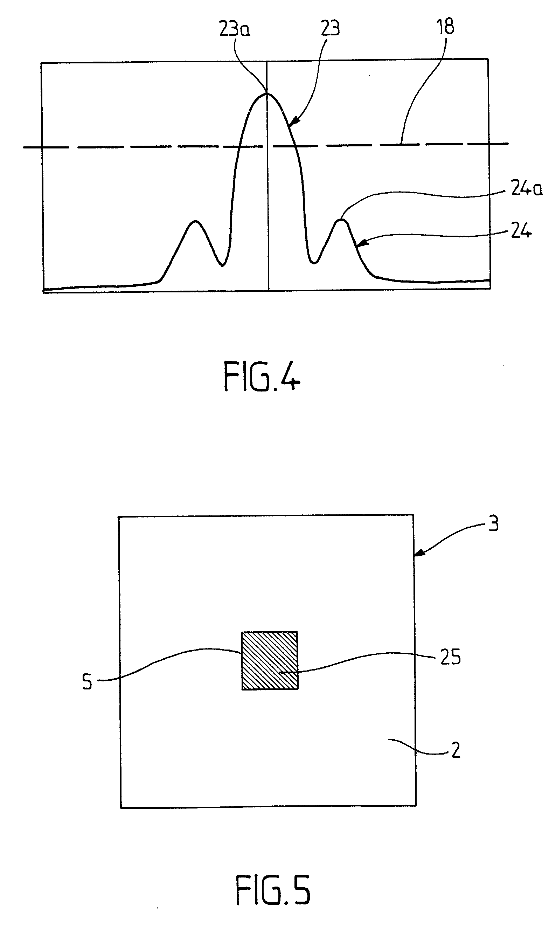

En se reportant à la figure 4, on voit que la dose cumulée 23 de lumière atteignant la couche de résine photo-sensible 2 de la plaquette 3 et résultant des illuminations suscessives au travers du trou central 15 du motif 14 du premier masque 13 et du trou unique 21 du motif 20 du second masque 19 se présente sous la forme d'une cloche 23 et que les valeurs maximum 17a et 22a précitées des doses de lumière 17 et 22 sont choisies de telle sorte que le niveau maximum 23a de la dose cumulée 23 est situé au-dessus du niveau de dose utile 18. De plus, les doses 24 correspondant aux trous périphériques 16 du masque 13 présentent respectivement un niveau maximum 24a qui reste inférieur au niveau de dose utile 18.

Il résulte de ce qui précède que, comme le montre la figure 5, la couche de résine photo-sensible 2 de la plaquette 3 se trouve insolée sur une zone 25 qui correspond à la coupe de la dose cumulée 23 au niveau de la dose utile 18.

Ainsi, une attaque ultérieure de la couche de résine photo-sensible 2 de la plaquette 3 permettra de réaliser, à l'endroit de la zone insolée 25, le trou 5 souhaité.

La présente invention ne se limite pas à l'exemple ci-dessus décrit. En particulier, les motifs 14 et 20 pourraient être réalisés en deux endroits d'un masque unique. Par ailleurs, les deux expositions décrites pourraient être inversées.

## Revendications

1. Procédé d'illumination d'une couche d'une matière, en particulier une résine photosensible, à partir d'une source de lumière en vue d'exposer une zone de cette matière à une dose utile de lumière permettant de réaliser ultérieurement une attaque de cette matière dans cette zone, **caractérisé par le fait qu'**il consiste :
- à placer entre la source de lumière (6) et la couche de matière (2) un premier masque (13) présentant un motif (14) composé d'un trou central (15) et de trous (16) placés à la périphérie de ce trou central ;
- à effectuer une première exposition au travers dudit motif dudit premier masque sous une première dose de lumière (17) inférieure à ladite dose utile (18) ;
- à placer entre la source de lumière et la couche de matière un second masque (19) présentant un motif (20) composé d'un trou unique (21), en disposant ce second masque dans une position telle que son trou unique corresponde au trou central du premier masque ;
- et à effectuer une seconde exposition au travers dudit motif dudit second masque sous une seconde dose de lumière (22) telle que le cumul (23) de ladite première dose (17) induite au travers du trou central (15) du premier masque (13) et de cette seconde dose (22) induite au travers du trou unique (22) dudit second masque (19) permette d'obtenir au moins ladite dose utile (18) sur ladite zone (25).

2. Procédé selon la revendication 1, **caractérisé par le fait qu'**il consiste : à effectuer la seconde exposition sous une seconde dose de lumière (22) inférieure à ladite dose utile (18).

3. Procédé selon l'une des revendications 1 et 2, **caractérisé par le fait que** le trou unique (15) du second masque (19) présente une surface supérieure à celle du trou central (15) du premier masque (13).

4. Procédé selon l'une quelconque des revendications précédentes, **caractérisé par le fait qu'**il consiste : à effectuer la première exposition sous une illumination quadripolaire ou annulaire.

5. Procédé selon l'une quelconque des revendications précédentes, **caractérisé par le fait qu'**il consiste : à effectuer la seconde exposition sous une illumination quadripolaire ou annulaire.

6. Procédé selon l'une quelconque des revendications précédentes, **caractérisé par le fait que** lesdits premier et second motifs (14, 20) sont réalisés sur un masque unique ou sur deux masques séparés.
